# EUROPEAN PATENT SPECIFICATION

(11) **EP 0 304 824 B1**
(45) Date of publication and mention of the grant of the patent: **17.03.1993**
(21) Application number: 88113531.3
(22) Date of filing: 19.08.1988
(51) Int. Cl.: H01L 29/78

(54) **Thin film mos transistor having pair of gate electrodes opposing across semiconductor layer**
Dünnschicht-MOS-Transistor mit zwei Gate-Elektroden, die gegenüber der halbleitenden Schicht liegen
Transistor MOS en couches minces ayant une paire d'électrodes de grille situées de part et d'autre de la couche semi-conductrice

(30) Priority: 24.08.1987 JP 209816/87
(43) Date of publication of application: 01.03.1989
(73) Proprietor: SONY CORPORATION, Tokyo 141 (JP)
(72) Inventor: Hayashi,Hisao Sony Corporation, Tokyo Kanagawa (JP); Negishi, Michio Sony Corporation, Tokyo Kanagawa (JP); Noguchi, Takashi Sony Corporation, Tokyo Kanagawa (JP); Oshima, Takefumi Sony Corporation, Tokyo Kanagawa (JP); Hayashi, Yuji Sony Corporation, Tokyo Kanagawa (JP); Maekawa, Toshikazu Sony Corporation, Tokyo Kanagawa (JP); Matsushita, Takeshi Sony Corporation, Tokyo Kanagawa (JP)
(74) Representative: TER MEER STEINMEISTER & PARTNER GbR

(56) References cited:
- GB-A- 2 064 866
- US-A- 4 422 090
- SOLID-STATE ELECTRONICS, vol. 22, no. 1, January 1979, pages 77-80, Pergamon Press Ltd; A.VAN CALSTER: "An experimental study of the indium antimonide thin film transistor"
- IDEM.
- IDEM.
- JAPANESE JOURNAL OF APPLIED PHYSICS, vol. 25, no. 4, part 2, April 1986, pages L291-L293, Tokyo, JP; T.OHSHIMA et al.: "A super thin film transistor in advanced poly Si films"
- IDEM.
- ELECTRONICS, vol. 58, no. 36, 9th September 1985, page 14, New York, US; C.L.COHEN: "New FET design could speed the arrival of 3-D circuits"
- IEEE ELECTRON DEVICE LETTERS, vol. EDL-3, no. 12, December 1982, pages 357-359, IEEE, New York, US; H.C.TUAN et al.: "Dual-gate aSi:H thin film transistors"

## Description

The present invention relates to a thin film MOS transistor having a pair of gate electrodes opposing across the channel region of the transistor.

From Electronics, 58 (1985) Sept., No. 36, p. 14, a thin film MOS transistor is known which comprises:
- a first gate electrode;
- a second gate electrode opposing said first gate electrode; and
- a semiconductor active layer formed between said first and second gate electrodes and defining a source region, a drain region and a channel region;
- whereby said channel region is defined between said source and said drain regions and opposes said first gate electrode via a first insulating layer, and opposes said second gate electrode via a second insulating layer.

In this prior art MOS transistor, the two opposing gate electrodes have the same length, however the second gate electrode holds a shorter distance from the channel region than the first gate electrode as the second insulating layer is thinner than the first insulating layer. The article gives no information why the different thicknesses of the insulating layers are chosen. Both gate electrodes are longer than the channel region, i. e. they partially overlap the source region and the drain region. This increases parasitic capacities between the gate electrodes and the source and drain regions. Such capacities decrease the operating speed of the transistor.

US-A-4,422,090 describes a very similar thin film MOS transistor. The main difference is that the two gate electrodes are not opposing each other within their entire lengths but that the second gate electrode comprises a middle portion which is spaced from the channel region via a second insulating layer, and additionally comprises a source side portion which is spaced from the active layer via a source electrode and said second insulating layer, and comprises a drain side portion which is spaced from the active layer via a drain electrode and said second insulating layer. The middle portion has a certain gate length which is shorter than the entire length of the second gate electrode. Only within said gate length the second gate electrode performs gate function. The distance of the middle portion of the second gate electrode from the channel region is the same as the distance of the first gate electrode from the channel region. The length of this middle portion is shorter than the length of the first gate electrode. However, the overall length of the second gate electrode, i. e. the length covering the source portion, the middle portion, and the drain portion is larger than the length of the first gate electrode. The first gate electrode overlaps the drain and source regions, this leading to the deficiencies as discussed above.

It is the object of the present invention to provide a thin film MOS transistor having a pair of gate electrodes opposing across the active layer, which transistor has low parasitic capacities between the gate electrodes and the source region and/or drain region.

The transistor of the present invention has the above listed features of the prior art transistor, and it is characterized in that
- the second gate electrode is non-overlapping with the source region and the drain region;
- the gate length l₁ of said first gate electrode is shorter than the gate length l₂ of said second gate electrode; and
- said semiconductor active layer is in self-alignment with said first gate electrode.

As the first gate electrode is shorter than the second one, and as the second one provides for self-alignment of the source and drain regions, it is guaranteed that the first gate electrode does not overlap with the source region and/or the drain region. Obviously this provides for small parasitic capacities between the first gate electrode and the source region and/or the drain region.

According to a preferred improvement of the transistor of the present invention, the thickness of said second insulating layer is selected to be thinner than that one of said first insulating layer. This arrangement of the gate electrodes relative to the active layer is preferred for maintaining the input capacity level equivalent to that one of a single gate type MOS transistor. This is achieved by setting the input capacity created by the first gate electrode small by providing a greater distance to the active layer.

The present invention will be understood more fully from the detailed description given here below and from the accompanying drawings of the preferred embodiment of the invention, which, however, should not be taken to limit the invention to the specific embodiment but are for explanation and understanding only.

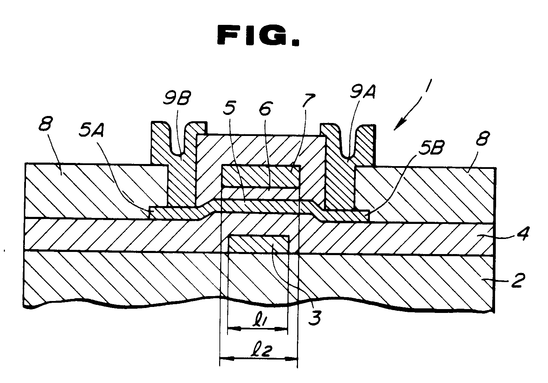

The figure shows a sectional view of a thin film MOS transistor according to the preferred embodiment of the present invention.

Referring now to the drawing a thin film MOS transistor according to the present invention is generally referred to by the reference numeral "1". The MOS transistor 1 has a substrate 2 which is made of quartz. A gate electrode 3 of polycrystalline silicon is formed on the quartz substrate 2. The polycrystalline silicon gate electrode 3 will be hereinafter referred to as "first gate electrode". An insulation layer 4 of silicon dioxide (SiO₂) is formed over the quartz substrate surface and over the polycrystalline silicon gate electrode 3.

An active layer 5 of semiconductor layer is formed on the surface of the silicon dioxide insulation layer 4. In the shown embodiment, the semiconductor active layer 5 is formed of polycrystalline silicon, by way of chemical vapor deposition and other appropriate process. The thickness of the semiconductor active layer 5 is in a range of less than or equal to 100 nm.

Though the shown embodiment of the thin film MOS transistor employs polycrystalline silicon to form the semiconductor active layer, any other material appropriate to use, can be used for forming the semiconductor active layer. For example, monocrystalline silicon can be used in place of the polycrystalline silicon for forming the semiconductor active layer.

In the shown embodiment, the semiconductor active layer 5 is formed as P-type layer. N⁺ type impurity is doped at both lateral end portions of the semiconductor active layer for forming a source region 5A and a drain region 5B.

A gate insulation layer 6 and a gate electrode 7 are formed on the semiconductor active layer 5. The gate electrode 7 will be hereinafter referred to as "second gate electrode". The gate insulation layer 6 is formed of silicon dioxide. On the other hand, the second gate electrode 7 is formed of polycrystalline silicon. These silicon dioxide gate insulation layer 6 and the second polycrystalline silicon gate electrode 7 are arranged on the semiconductor active layer 5 in alignment with the first polycrystalline silicon gate electrode 3. As will be seen from the drawing, the thickness of the silicon dioxide gate insulation layer 6 is thinner than that of the insulation layer 4. Therefore, the distance between the second polycrystalline silicon gate electrode 7 to the opposing surface of the semiconductor active layer 5 is set smaller than that between the first polycrystalline silicon gate electrode 3 and the opposing surface of the semiconductor active layer 5. As a result, the working function of the second polycrystalline silicon gate electrode 7 become greater than that of the first polycrystalline silicon gate electrode 7.

As far as the electron mobility is concerned, even distance between the gate electrodes and the active layer may exhibit equivalent performance to that of the shown embodiment. However, the shown arrangement of the gate electrodes relative to the active layer is preferred because of the above discussed reasons.

Additionally, the MOS transistor 1 has an insulation layer 8 and aluminium electrodes 9A and 9B for external connection. The aluminium electrodes 9A and 9B are respectively connected to the source region 5A and the drain region 5B of the semiconductor active layer.

The shown embodiment further features a novel geometry which allows easy alignment of the first and second polycrystalline silicon gate electrodes 3 and 7. In the shown embodiment, the second polycrystalline silicon gate electrode 7 has a gate length ℓ₂. On the other hand, the first polycrystalline silicon gate electrode 3 has a gate length ℓ₁ which is shorter than the gate length ℓ₂ of the second polycrystalline silicon gate electrode 7.

In production, the semiconductor active layer 5 is formed in self-alignment with the first polycrystalline silicon gate electrode 7. Therefore, even when the first and second polycrystalline silicon gate electrodes 3 and 7 mutually offset to off center the each other, the first polycrystalline silicon gate electrode can be maintained beneath the second polycrystalline silicon gate electrode and beneath the region (channel region) between the source and drain regions 5A and 5B of the semiconductor active layer 5.

Therefore, the first polycrystalline silicon gate electrode 3 will never be placed in a position partially or in whole opposing one of the source and drain regions 5A and 5B. This minimizes parasitic capacity created between the first polycrystalline silicon gate electrode and one of the source and drain regions. Therefore, element characteristics of the MOS transistor can be maintained acceptable.

Furthermore, since the shown geometry does not require substantial precision in fabrication, production of such MOS transistor become easier with substantially high yield.

## Claims

1. A thin film MOS transistor (1) comprising:
- a first gate electrode (3);
- a second gate electrode (7) opposing said first gate elecrode; and
- a semiconductor active layer (5) formed between said first and second gate electrodes and defining a source region (5A), a drain region (5B) and a channel region;
- whereby said channel region is defined between said source and said drain regions and opposes said first gate electrode via a first insulating layer (4), and opposes said second gate electrode via a second insulating layer (6); characterized in that
- the second gate electrode is non-overlapping with the source region (5A) and the drain region;
- the gate length (l₁) of said first gate electrode (3) is shorter than the gate length (l₂) of said second gate electrode (7); and
- said semiconductor active layer (5) is in self-alignment with said second gate electrode (7).

2. A thin film MOS transistor (1) as set forth in claim 1, characterized in that said second insulating layer (6) is thinner than said first insulating layer (4).

## Patentansprüche

1. Dünnfilm-MOS-Transistor (1) mit:
- einer ersten Gateelektrode (3);
- einer zweiten Gateelektrode (7), die der ersten Gateelektrode gegenübersteht; und
- einer aktiven Halbleiterschicht (5), die zwischen der ersten und der zweiten Gateelektrode ausgebildet ist und einen Sourcebereich (5A), einen Drainbereich (5B) und einen Kanalbereich festlegt;
- wobei der Kanalbereich zwischen dem Source- und dem Drainbereich festgelegt ist und der ersten Gateelektrode über eine erste isolierende Schicht (4) gegenübersteht und der zweiten Gateelektrode über eine zweite isoliereden Schicht (6) gegenübersteht;
**dadurch gekennzeichnet,** daß
- die zweite Gateelektrode nicht mit dem Sourcebereich (5A) und dem Drainbereich überlappt;
- die Gatelänge (l₁) der ersten Gateelektrode (3) kürzer ist als die Gatelänge (l₂) der zweiten Gateelektrode (7); und
- die aktive Halbleiterschicht (5) in Selbstausrichtung mit der zweiten Gateelektrode (7) steht.

2. Dünnfilm-MOS-Transistor (1) nach Anspruch 1, **dadurch gekennzeichnet,** daß die zweite isolierende Schicht (6) dünner ist als die erste isolierende Schicht (4).

## Revendications

1. Transistor MOS (1) à couches minces, comprenant :
une première électrode de grille (3);
une deuxième électrode de grille (7) située en regard de ladite première électrode de grille ; et
une couche active semiconductrice (5) formée entre lesdites première et deuxième électrodes de grille et définissant une région de source (5A), une région de drain (5B) et une région de canal;
de sorte que ladite région de canal est définie entre ladite région de source et ladite région de drain et qu'elle est en regard de ladite première électrode de grille via une première couche isolante (4) et en regard de ladite deuxième électrode de grille via une deuxième couche isolante (6);
caractérisé en ce que:
la deuxième électrode de grille est sans chevauchement avec la région de source (5A) et la région de drain;
la longueur de grille (ℓ₁) de ladite première électrode de grille (3) est plus courte que la longueur de grille (ℓ₂) de ladite deuxième électrode de grille (7); et
ladite couche active semiconductrice (5) est en auto-alignement avec ladite deuxième électrode de grille (7).

2. Transistor MOS (1) à couches minces selon la revendication 1, caractérisé en ce que ladite deuxième couche isolante (6) est plus mince que ladite première couche isolante (4).
